# EUROPEAN PATENT APPLICATION

(11) **EP 4 716 404 A1**
(43) Date of publication of application: **25.03.2026**
(21) Application number: 24202203.6
(22) Date of filing: 24.09.2024
(51) Int. Cl.: H10D 30/01, H10D 30/00, H10D 64/01, H10D 84/85, H10D 30/43, B82Y 10/00

(54) **METHOD FOR FORMING A BACK-SIDE SOURCE/DRAIN CONTACT**

(71) Applicant: Imec VZW, 3001 Leuven (BE)
(72) Inventor: VELOSO, Anabela, 3001 Leuven (BE); HORIGUCHI, Naoto, 3000 Leuven (BE)
(74) Representative: AWA Sweden AB

(57) **Abstract**

According to an aspect of the present inventive concept there is provided a method for forming a source/drain contact, the method comprising: providing at least one fin (110) on top of a substrate (130), the at least one fin (110) comprising at least a first set of channel layers (111), the at least one fin (110) being arranged between a first and second shallow trench isolation, STI, region (151, 152) extending into the substrate (130); from a frontside (134) of the substrate (130): forming a cavity (136) in the substrate (130) proximate to the at least one fin (110), forming a sacrificial plug (160) in the cavity (136), and forming a source/drain region (170) on top of the sacrificial plug (160), and in contact with the first set of channel layers (111) of the at least one fin (110); and from a backside (135) of the substrate (130): removing a first region (138) of the substrate (130), the first region (138) of the substrate (130) being a region between the first and second STI region (151, 152) and around the sacrificial plug (160), forming a dielectric material (180) between the first and second STI region (151, 152) and around the sacrificial plug (160), and replacing the sacrificial plug (160) with a metal (190) such that the metal (190) is in electrical contact with the source/drain region (170), wherein a bottom level of the cavity (136) is substantially equal to a bottom level of the first and second STI region (151, 152).

## Description

### Technical field

The present inventive concept relates to semiconductor device fabrication, specifically a method for forming backside contacts for source and/or drain regions in field-effect transistors (FETs).

### Background

In the prior art, power distribution in advanced semiconductor nodes has traditionally been managed from the front side of the wafer. However, as device scaling continues, moving power distribution to the wafer's backside has become a relevant element in the compute scaling roadmap. Various schemes have been previously proposed to implement backside power distribution, with direct backside contact to the transistor's source being one of the most promising approaches due to its potential for higher cell scalability. Such a scheme is especially relevant for nanosheet (NS) FET devices and bottom devices in 3D-stacked structures like Complementary FETs (CFETs).

This relevance is underscored by the current technological timeline, as NS-based devices, including CFETs, are widely regarded as the most promising candidates for several forthcoming technology nodes in the logic roadmap.

However, further improvements and ways for implementation are possible.

### Summary

It is a realization that there are challenges in backside processing of a wafer having a device built on a frontside of the wafer, since this involves wafer distortion caused by bonding, which affects overlay control during backside lithography, and the possibility of having presence of parasitic current paths in the substrate.

Hence, it is a realization that there is a need for a more robust and manufacturable method for providing backside power distribution that mitigates the impact from wafer distortion and parasitic current paths, while ensuring high scalability and performance for advanced semiconductor devices.

An objective of the present inventive concept is to provide a method to introduce backside contacts on the source and/or drain of a FET (e.g., a single-level NSFET or on a bottom device of a 3D stacked structure such as CFET).

Another objective is to develop a robust, manufacturable, and simplified scheme that can obtain optimized device performance. In particular, it is an objective to reduce or avoid the need for backside lithography for definition of a first backside metallization level.

A further objective is to provide a method applicable to both bulk silicon (Si) and Silicon-On-Insulator (SOI) substrate wafers.

Yet another objective is to provide a method where a substrate may be removed under a logic device area, while some substrate may remain on other parts of the die for specific applications.

An additional objective is to minimize parasitic paths in the substrate to enhance device performance and reliability.

To achieve at least one of the above objectives, and also other objectives that will be evident from the following description, there is according to an aspect of the present inventive concept provided a method for forming a source/drain contact.

The method comprises:
providing at least one fin on top of a substrate, the at least one fin comprising at least a first set of channel layers, the at least one fin being arranged between a first and second shallow trench isolation, STI, region extending into the substrate;
from a frontside of the substrate:
   forming a cavity in the substrate proximate to the at least one fin,
   forming a sacrificial plug in the cavity, and
   forming a source/drain region on top of the sacrificial plug, and in contact with the first set of channel layers of the at least one fin; and from a backside of the substrate:
      removing a first region of the substrate, the first region of the substrate being a region between the first and second STI region and around the sacrificial plug,
      forming a dielectric material between the first and second STI region and around the sacrificial plug, and
      replacing the sacrificial plug with a metal such that the metal is in electrical contact with the source/drain region,
   wherein a bottom level of the cavity is substantially equal to a bottom level of the first and second STI region.

Hereby, a source/drain contact is formed by the metal replacing the sacrificial plug.

Relative spatial terms such as "top", "bottom", "lower", "vertical", "stacked on top of", are herein to be understood as denoting locations or directions within a frame of reference of the substrate. In particular, the terms may be understood in relation to a normal direction to the substrate on which the fin is provided. Correspondingly, terms such as "lateral" and "horizontal" are to be understood as locations or directions parallel to the substrate.

The source/drain contact may be a contact for a semiconductor device, e.g. a transistor, such as a FET. The source/drain contact may be formed during production of the FET. Producing the entire FET may comprise further steps.

In accordance with the above, the fin may be a fin for a FET. The fin comprises a first set of channel layers. The first set of channel layers may comprise at least one channel layer for charge transport. The channel layers may be part of a stack of layers forming the fin. If the fin is intended for a NSFET, the fin may comprise solely the first set of channel layers. If the fin is intended for a CFET, the fin may comprise a second set of channel layers above the first set of channel layers. A CFET may comprise two FETs stacked on-top of each other, wherein the (bottom) first set of channel layers is for the bottom FET and the (top) second set of channel layers is for the top FET. Thus, in the case of producing a CFET, the source/drain contact may be formed to a source/drain region of the bottom FET.

The fin may comprise two opposing lateral side faces, two opposing lateral end faces, and a top face. Each channel layer may comprise a semiconductor, e.g. silicon. The substrate may comprise a semiconductor. The substrate may be e.g. a silicon substrate or a silicon-on-insulator substrate.

The source/drain region may be one of two source/drain regions arranged at opposite ends of the channel layers, i.e. at the opposing lateral end faces of the fin. The source/drain region may comprise a semiconductor or a combination of semiconductor materials, e.g., silicon, Si₁₋ₓGeₓ, (where x may range from 0.1 to 0.9), etc. The source/drain region may be doped, e.g. p doped when belonging to a pFET or n doped when belonging to a nFET. In the finished FET, the current may flow in the channel layers between the above mentioned two source/drain regions.

The expression 'source/drain' may be interpreted as 'source and/or drain'. The source/drain contacts may further correspond to the metal being in contact with the source/drain region. The frontside of the substrate is defined as the side on which the at least one fin is fabricated on the substrate, while the backside of the substrate is the opposite side to the frontside.

Accordingly, the contact formed by the method may be referred to as a backside contact, since the source/drain region is formed on top of the sacrificial plug which is later replaced by metal. In other words, said metal is formed below the source/drain region, i.e. towards the backside of the substrate.

Processing may be performed from the frontside or from the backside. Before performing a processing step from the backside, the device (e.g. the FET) may be embedded in support material, e.g. dielectric material, and bonded to a carrier wafer from the frontside. The substrate may then be partially or fully removed to facilitate processing from the backside. During processing from the backside, the structure may be flipped upside down. However, in the interest of clarity, a single frame of reference is used throughout this disclosure (unless otherwise stated).

In view of the above, the method may be seen as a method for forming a backside contact, wherein part of the processing steps of the method are performed from the frontside. By forming the cavity; the sacrificial plug; and the source/drain region from the frontside and later removing the first region of the substrate; forming the dielectric material; and replacing the sacrificial plug from the backside, the need for backside lithography may be reduced or avoided. For example, the position and/or extent of the backside contact may not need to be lithographically defined from the backside but may instead be defined by the formation of the cavity from the frontside. Thus, even if the structure is bonded to a carrier wafer before backside processing, and even if said bonding causes wafer distortion, the position and/or extent of the backside contact may still be controlled with a high accuracy.

A contact to the source of the FET may be formed by the method. Similarly a contact to the drain of the FET may be formed by the method. It should also be understood that both the contact to the source and the contact to the drain may respectively be formed by the method. In the case where one source/drain contact is formed by the method and the other source/drain contact is formed by another method, said other method may be a method for forming a frontside contact or another (different) method for forming a backside contact.

The source/drain contact, the at least one fin, and/or the channel region between source and drain, may be referred to as the active area.

The active area may be surrounded by STI. The STI surrounding the active area may comprise the first and second STI region. In other words, the at least one fin may be surrounded by STI on all lateral sides thereof. Specifically, the fin (or active area) may be surrounded by STI.

The first and second STI region may be neighboring STI regions.

Providing the fin on top of the substrate may comprise forming a stack of layers, e.g. by epitaxial growth, the stack of layers comprising channel layers. The fin may then be etched out of the stack of layers. The first and second STI region may then be formed by etching trenches into the substrate and filling said trenches with dielectric material. As will be discussed further below, a region of the substrate between the first and second STI region may be called a first region of the substrate. Thus, the fin may be seen as arranged on-top of the first region of the substrate. The fin may be seen as arranged at a lateral position between the respective lateral positions of the first and second STI regions.

The forming of the cavity in the substrate proximate to the at least one fin may involve forming the cavity under what will later become the source/drain region. The position and/or lateral extent of the cavity may primarily be lithographically defined or set. Alternatively, the cavity may be self-aligned to the fin. The cavity may be formed by etching, e.g. wet or dry etching, into the substrate.

The sacrificial plug in the cavity may be formed in the cavity by any method e.g. epitaxial growth or deposition.

The source/drain region may be formed on top of the sacrificial plug by epitaxial growth, e.g. epitaxial growth on the end face of the fin.

As previously mentioned, some of the processing steps for the source/drain contact are performed from the backside of the substrate.

The first region of the substrate is removed from the backside. The first region of the substrate being a region between the first and second STI region and around the sacrificial plug. In order to access the first region of the substrate, part of the substrate below said first region may be removed by, e.g., a combination of grinding and chemical mechanical polishing (CMP). Thus the substrate may be removed up to the bottom level of the first and second STI by grinding and/or CMP. Thereafter, the first region of the substrate may be removed by etching, e.g. wet etching and/or dry etching.

As mentioned, a dielectric material is then formed between the first and second STI region and around the sacrificial plug. Either one single dielectric material or more dielectric materials may be formed. The dielectric material may be formed by deposition, e.g. oxide deposition. Thus, the dielectric material may surround the sacrificial plug (which later will be transformed into the source/drain contact). Accordingly, said dielectric material may provide bottom device isolation which may, e.g. together with the first and second STI regions, remove or reduce parasitic paths (e.g. current paths) to the substrate.

Replacing the sacrificial plug with a metal (or metals) may be performed by metal deposition, e.g. evaporation, sputtering, or atomic layer deposition (ALD) of metal(s). One or more metals may be deposited. In particular, a contact metallization provided by the metal may consist of more than one metal material.

As mentioned, the bottom level of the cavity is substantially equal to the bottom level of the first and second STI region. In other words, the bottom level of the cavity is arranged at substantially the same height as the bottom levels of the first and second STI regions. Phrased differently, the bottom level of the cavity may be in level with the bottom level of the first and second STI region. The bottom level of the cavity being substantially equal to the bottom level of the first and second STI region may, e.g., correspond to a distance between the bottom level of the cavity and the bottom level of the first and second STI region being within (+/-) 10 nm, preferably within (+/-) 5 nm. It is a realization that having the bottom level of the cavity substantially equal to the bottom level of the first and second STI region is advantageous. When the substrate below the first region of the substrate is removed, e.g., by CMP, it is advantageous to stop the act of removing at the bottom levels of the first and second STI regions. Thus, the CMP may not proceed into the first and second STI regions which may cause imperfections such as scratches, defects, flatness issues or distortions. Further, the CMP stopping at the bottom of the STI regions (due to the liner at the bottom of the STI regions behaving as a CMP-stop-layer), a controllable CMP process is enabled.

Consider the case where the bottom level of the cavity is above the bottom levels of the first and second STI regions, meaning that the bottom level of the sacrificial plug is above the bottom levels of the first and second STI regions. In this case, during formation of dielectric material around the sacrificial plug, dielectric material deposited below the sacrificial plug may be difficult to remove. Thereby, replacing the sacrificial plug with metal may be difficult due to requiring further processing. For example, CMP removal of dielectric material deposited below the sacrificial plug may be difficult if the bottom level of the cavity is above the bottom levels of the first and second STI regions. In such cases, CMP alone may not be sufficient without consuming a significant amount of STI, thus necessitating overpolishing, which could have disadvantageous consequences. Therefore, additional steps may be required to effectively remove the dielectric material below the sacrificial plug.

Consider the case where the bottom level of the cavity is below the bottom levels of the first and second STI regions, meaning that the bottom level of the sacrificial plug is below the bottom levels of the first and second STI regions. In this case, removal (e.g. by CMP) of the substrate below the first region of the substrate may need to proceed into the sacrificial plug, which may cause imperfections such as scratches, defects, flatness issues or distortions. Further, before the CMP stops at the bottom of the STI regions, parts of the sacrificial plug may be removed or consumed, which may lead to the creation of defects.

By having the bottom level of the cavity substantially equal to the bottom level of the first and second STI region, the above problems may be avoided or mitigated.

In view of the above, there is provided a robust and simplified method for forming backside contacts on source and/or drain contacts, e.g. of single-level FETs (such as NSFETs) or of bottom devices of 3D stacked structures such as CFETs.

Further, the isolation provided by the dielectric material improves isolation such that parasitic current paths via the substrate are removed or reduced. This may in turn render Ground Plane Doping (introduced in the semiconductor, e.g., Si, substrate for providing electrical isolation of devices) non-necessary, which can be used for devices where electrical isolation is not required.

The method further enables self-aligned backside contacts to source/drain epitaxy on the substrate's frontside, thereby ensuring precise and reliable connections.

The replacing of the sacrificial plug with the metal such that the metal is in (direct) electrical contact with the source/drain region avoids or reduces the need for a critical lithography step on the backside of the substrate. Hence, eliminating the dependency on high-precision lithography for backside contacts, thereby reducing the impact of overlay control on device characteristics. Subsequent backside lithography steps become less critical, hereby simplifying the manufacturing process.

Additionally, minimized device external resistance and improved contact surface area/contact resistance is provided, thereby enhancing electrical performance and reducing power loss.

Moreover, the method is applicable to both bulk and silicon-on-insulator (SOI) substrates, thereby offering flexibility in wafer thinning processes.

The at least one fin may comprise a first and a second fin, wherein the first and second fin may be separated by a source/drain recess, and wherein the cavity may be formed below the source/drain recess.

In other words, the cavity may be formed relative to the first and second fin. Hence, the forming of the cavity may be assisted by the fins. Thus, the cavity may be formed by extending the source/drain recess into the substrate, e.g. by etching. The first and second fins may thus act as etch masks for forming the cavity. The cavity may thereby be self-aligned to the first and second fins.

A source/drain region formed in said source/drain recess may be shared between the first and second fins.

The at least one fin may be any plurality of fins, e.g. such that neighboring fins may be separated by a source/drain recess and/or a cavity may be formed below each source/drain region.

The method may further comprise: forming an etch-stop layer on a bottom surface of the sacrificial plug and on respective bottom surfaces of the first and second STI region, before forming the dielectric material between the first and second STI region and around the sacrificial plug, wherein forming the dielectric material comprises also forming the dielectric material below the sacrificial plug; removing the dielectric material below the sacrificial plug selectively to the etch-stop layer on the bottom surface of the sacrificial plug by etching and/or chemical mechanical polishing, CMP; and removing the etch-stop layer from the bottom surface of the sacrificial plug before replacing the sacrificial plug with metal.

The bottom surface of the sacrificial plug and the bottom surfaces of the first and second STI region may be defined as bottom surfaces when viewed from the frontside of the substrate. Notably, during manufacturing, the substrate may be flipped up-side-down (i.e. 180 degrees) for the backside processing steps, however, one single frame of reference is used here for clarity purposes.

The etch-stop layer may conformally coat exposed surfaces of the sacrificial plug and the STI regions. Thus, the etch-stop layer may be seen as a liner. The etch-stop layer may be configured such that the etch or CMP used to remove the dielectric material below the sacrificial plug has a lower removal rate for the material of the etch-stop layer than for the dielectric material. The etch-stop layer may, e.g., comprise silicon nitride (SiN).

The etch-stop layer may hereby prevent further etching or CMP beyond a specified depth, thereby providing precise control over the etching process and protecting underlying layers from damage during etching or CMP.

As previously mentioned, the sacrificial plug in the cavity may be formed in the cavity by any suitable method. Advantageously, the sacrificial plug may be formed by epitaxial growth.

In other words, the sacrificial plug, which may be a temporary structure used during the manufacturing process, may be created using a method of epitaxial growth. Epitaxial growth may refer to the deposition of a crystalline layer on the substrate, where the deposited layer follows the crystallographic orientation of the substrate. Hence, the sacrificial plug may have a high degree of structural integrity and uniformity.

Forming the sacrificial plug by epitaxial growth facilitates the formation of the source/drain region on top of the sacrificial plug. For example, if the sacrificial plug is epitaxially grown (and thereby have a crystalline structure) then the source/drain region may be epitaxially grown both on/from the end faces of the channel layers and on/from the sacrificial plug with minimized or no defects being formed.

The material or materials of the sacrificial plug may be any suitable material, e.g., a dielectric. If the sacrificial plug is formed by epitaxial growth, the material of the sacrificial plug may be a semiconductor material. In a particular example, the sacrificial plug may formed using an epitaxial layer such as Si₁₋ₓGeₓ.

The sacrificial plug and the source/drain region may comprise a same material. Using a same material facilitates the formation of the source/drain region, e.g. by epitaxial growth, with minimized or no defects. The sacrificial plug and the source/drain region may comprise a same semiconductor alloy. In such a case, the semiconductor alloy composition of the sacrificial plug and the source/drain region may be the same or may be different.

The use of different compositions for the sacrificial plug and the source/drain region may advantageously be used for induced strain engineering in the source/drain region. Further, the use of materials with varying compositions, such as different percentages of Ge in SiₓGe_{y} for the sacrificial plug and the source/drain region, may enhance source/drain epitaxial quality control, and maximize the strain induced in the channels by the source/drain region. Additionally, better control over the removal of the sacrificial plug and precise etching on or within the source/drain region may be provided.

Specifically, the sacrificial plug may be made of a similar material as the material of the source/drain region, i.e. the materials may have similar characteristics.

The step of forming the cavity may further comprise shaping the cavity such that a bottom part of the cavity comprises an inclined plane. In other words, the cavity may have a sloped profile.

The inclined plane may be a crystalline facet. A bottom part of the cavity may comprise several inclined planes, e.g. two inclined planes or two inclined planes in a V-shape.

When a bottom part of the cavity comprises an inclined plane, a larger contact surface is provided and/or epitaxial growth can be facilitated. Thus a sacrificial plug with no or fewer defects is facilitated. In addition, this facilitates a source/drain region (on top of the sacrificial plug) with no or fewer defects.

Further, when a bottom part of the cavity comprises an inclined plane, enlarging of the cavity may be facilitated. A cavity with flat bottom may be enlarged by developing several inclined planes.

Moreover, having the sloped profile at the bottom of the cavity may be beneficial if the cavity is to be filled with an epitaxial growth material (e.g. SiGe). Particularly, the sloped profile may provide better quality epitaxial material growth in terms of defect control. Having a less defective sacrificial plug is beneficial for control of subsequent epitaxial quality growth of source/drain region and for the removal process control of the sacrificial plug.

The step of forming the cavity may further comprise enlarging the cavity by lateral etching, such that a width of the enlarged cavity is larger than a width of the source/drain recess.

In other words, the cavity may be at least partially expanded sideways, such that a largest width of the cavity may be greater than the width of the source/drain recess. In yet other words, the width/volume of the bottom of the cavity may be larger than the width/volume of the source/drain recess.

The width of the source/drain recess may correspond to a distance between the first and second fin and/or a distance between any neighboring fins.

Enlarging the cavity may provide improved quality of epitaxial growth to fill the cavity. Further, when having a larger volume cavity/plug, replacing the sacrificial plug in the cavity (during backside processing) with metal(s) will provide a large volume of the metal(s), which provides reduced contact resistance and hence improved device performance. Hence, enlarging the cavity leads to higher conductivity and consequently improved performance.

The enlarging of the cavity may involve further processing steps beyond lateral etching. The cavity may be enlarged in such a way that it does not overlap with neighboring fin structures, e.g. by enlarging the bottom or a bottom/middle portion of the cavity through processing including limited or controlled lateral etching.

The method may further comprise protecting channel ends in the source/drain recess during the step of enlarging the cavity.

Protecting the channel ends may comprise forming a protective layer, such as on the side walls of the at least one fin, to resist lateral etching used for enlarging the cavity. This may comprise using specific etching processes that selectively avoid the channel ends and/or applying or forming a protective coating or layer (e.g., an etch-stop layer),e.g., prior to applying a directional etch that removes the protective layer at the bottom and prior to the etch process of enlarging the cavity. Thereby ensuring that the channels remain intact and undamaged during the enlarging of the cavity.

The substrate may be a silicon on insulator substrate comprising a silicon layer on top of a buried oxide layer.

The buried oxide layer beneath the silicon layer may, e.g., act as an insulator to minimize leakage currents and reduce power consumption. However, the silicon on insulator substrate may comprise a silicon layer positioned above any insulating layer.

The substrate may alternatively be any standard silicon bulk substrate (e.g., such as silicon wafer with or without a doped region, an epitaxial layer, a buried oxide layer, and/or a high-resistivity layer).

Part of the silicon layer of the silicon on insulator substrate may remain between the cavity and the oxide layer of the silicon on insulator substrate, after forming the cavity. In other words, the cavity may not extend into the oxide layer. By not having the bottom of the cavity reaching or touching the oxide layer, epitaxial growth from the bottom of the cavity is enabled.

Hence, the sacrificial plug may be protected during removal of the oxide layer, and the bottom level of the cavity may be more precise controlled to be substantially equal to the bottom level of the first and second STI region.

Replacing the sacrificial plug with the metal may further comprise: etching through the sacrificial plug and into the source/drain region such that an inclined plane is formed at a bottom of the source/drain region; and depositing the metal on the inclined plane of the source/drain region.

In other words, the bottom of the source/drain region may comprise a sloped profile. The bottom of the source/drain region may, e.g., comprise several inclined planes, e.g. two inclined planes or two inclined planes in an upside-down V-shape.

During the step of etching through the sacrificial plug, i.e. removing the plug material, additional material surrounding at least part of the source/drain region may be removed to enable a wrapped-around contact. Hence, enabling additional metal contact with the source/drain region not only from the bottom (i.e. the backside of the substrate) but also partially from the sides of the source/drain region. Thereby providing an enlarged contact surface area and consequently lower contact resistance.

In an example, the step of etching through the sacrificial plug and into the source/drain region such that an inclined plane is formed at a bottom of the source/drain region and the step of forming the cavity by shaping the cavity such that a bottom part of the cavity comprises an inclined plane, may not be mutually exclusive.

The method may further comprise: forming, from the backside, a metal interconnect line on the metal replacing the sacrificial plug. In other words, a conductive pathway may be provided on the backside of the substrate, e.g., interconnecting different metal contacts.

Hence, the metal interconnect line may be a conductive trace that facilitates electrical connectivity between different regions of a device comprising at least one source/drain contact. The metal interconnect line may be a buried power rail.

The method may further comprise protecting a second region of the substrate during the step of removing the first region of the substrate.

In other words, a certain area of the substrate may be safeguarded while another area is being etched or at least partly removed. Hence, the second region refer to the part of the substrate that remains intact and is shielded during the removal process of at least part of the first region.

The protecting of the second region may, e.g., be beneficial in a case where a part of the substrate is removed under logic device areas, while another part of the substrate remains for other applications. The second region of the substrate may, e.g., be part of a diode structure or any suitable semiconductor structure and/or generic device.

The second region may be protected by a shallow trench isolation liner or a dielectric liner (e.g., a silicon nitride liner), hence serving as an etch-stop-layer during removal of the first region of the substrate.

Hereby, selective removal of the substrate material is provided.

The method may further comprise providing, in addition to the at least one fin, a semiconductor structure on top of the substrate. In other words, in addition to logic devices (e.g., NSFETs or CFETs), another semiconductor structure or structures may be provided on top of the substrate.

The semiconductor structure on top of the substrate may be any suitable structure or combination of structures. For example, the semiconductor structure may be any non-logic device, e.g., such as a diode and/or a ESD protection diode.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 0 schematically illustrates a cross-section of a fin arranged on a substrate and between a first and second STI region.
Fig. 1A-N schematically illustrates steps of a method for forming a source/drain contact.
Fig. 2A-F schematically illustrates steps of a method for forming a source/drain contact for a semiconductor device comprising one fin.
Fig. 3A-B schematically illustrates alternative and/or additional steps of shaping a cavity and sacrificial plug of a method for forming a source/drain contact.
Fig. 4A-B schematically illustrates alternative and/or additional steps of enlarging a cavity and sacrificial plug of a method for forming a source/drain contact.
Fig. 5A-C schematically illustrates alternative and/or additional steps of shaping a source/drain contact of a method for forming said source/drain contact.
Fig. 6A-D schematically illustrates elected steps of a method for forming a source/drain contact wherein a sacrificial plug and a source/drain region are made of a same material.
Fig. 7A-E schematically illustrates additional steps of forming a metal interconnect line in a method for forming a source/drain contact.
Fig. 8A-C schematically illustrates steps of a method for forming a source/drain contact in a first region of a substrate of a semiconductor device comprising a semiconductor structure in a second region of the substrate.

### Detailed description

In the following, the method is exemplified as a method for producing a source/drain contact to a CFET. Alternatively, the method may be used for producing a source/drain contact to e.g. a NSFET. The figures described in the following show, unless otherwise stated, cross-sections of fins comprising channel layers, wherein the cross-sections are parallel with the direction of the current flow in the finished FET. Accordingly, in the finished FET, the current flows from left to right or vice versa.

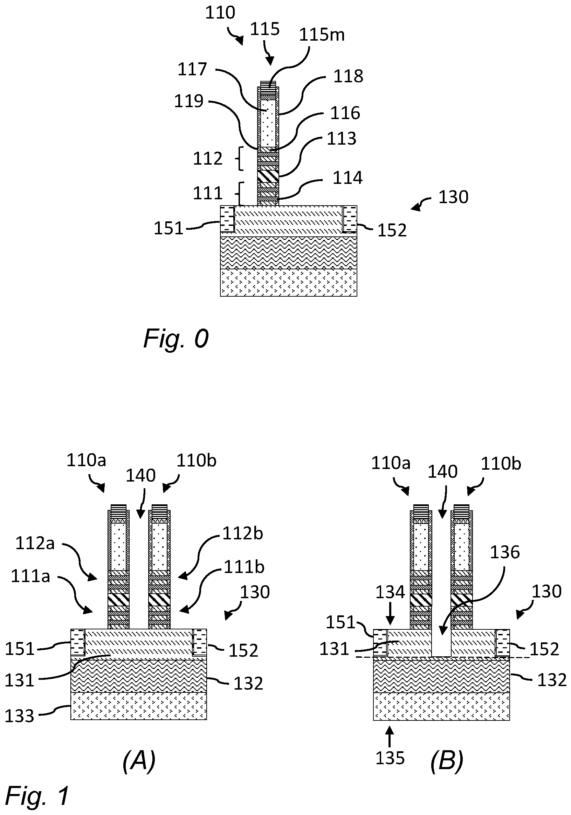

Fig. 0 is a cross-section of a substrate 130 and a fin 110, the fin 110 being arranged between a first and second STI region 151, 152, respectively extending into the substrate 130. The illustrated fin 110 comprises a first and a second set of channel layers 111, 112. The illustrated fin 110 may be seen as a fin 110 for producing a CFET. Thus, the illustrated first set of channel layers 111 may be used to produce a bottom FET. The illustrated second set of channel layers 112 may be used to produce a top FET. The illustrated fin 110 further comprises middle (vertical) dielectric isolation 113 for electrically (vertically) separating the top and bottom FET. The middle dielectric isolation 113 may comprise dielectric material.

As an alternative to a fin 110 comprising a first and a second set of channel layers 111, 112, the fin 110 may comprise a single set of channel layers. Such a fin may lack middle dielectric isolation 113. A fin comprising a single set of channel layers may be used for producing a NSFET. Although not shown, it is to be understood that the any suitable number of sets of channel layers may be used, a number of stacked channels may, e.g., be one or more.

The fin 110 may further, as illustrated, comprise a gate 115. The gate 115 is a dummy gate and will at a later stage be replaced by a replacement metal gate (RMG) process. The dummy gate 115 comprises a gate mask 115m and further comprise a thin-dummy-oxide/aSi layer (not shown). Accordingly, after RMG, the gate stack may be arranged in a gate all around (GAA) arrangement. The gate 115 may then, after RMG, further comprise gate fill material 117, as schematically illustrated in a simplified manner in Fig. 0. Gate spacers 118 are here arranged on sides the gate fill material 117.

Fig. 0 illustrates the fin 110 before the step of forming the sacrificial plug and before the step of forming the source/drain region. In the finished device, one source/drain region may be formed to the left of the illustrated fin 110 and another source/drain region may be formed to the right of the illustrated fin 110. Further, in Fig. 0, inner spacers 119 are arranged to electrically isolate such future source/drain regions from the gate 115.

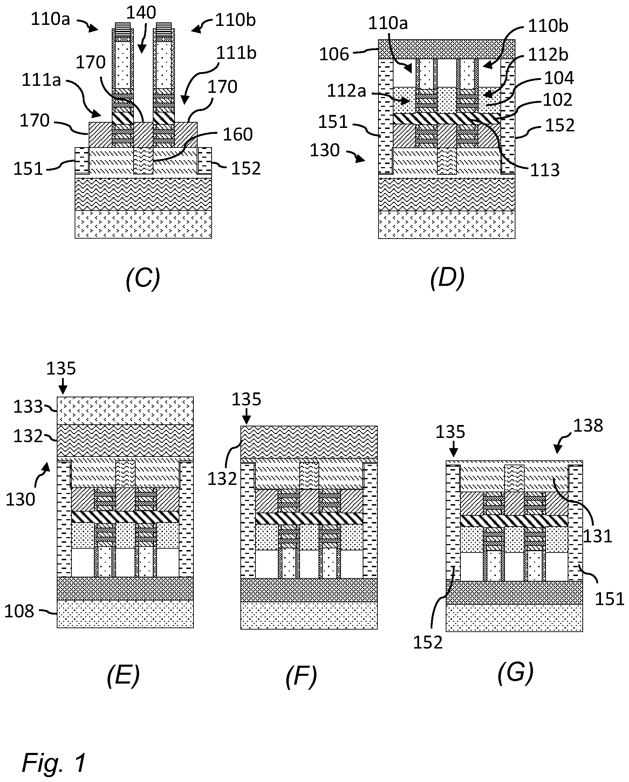

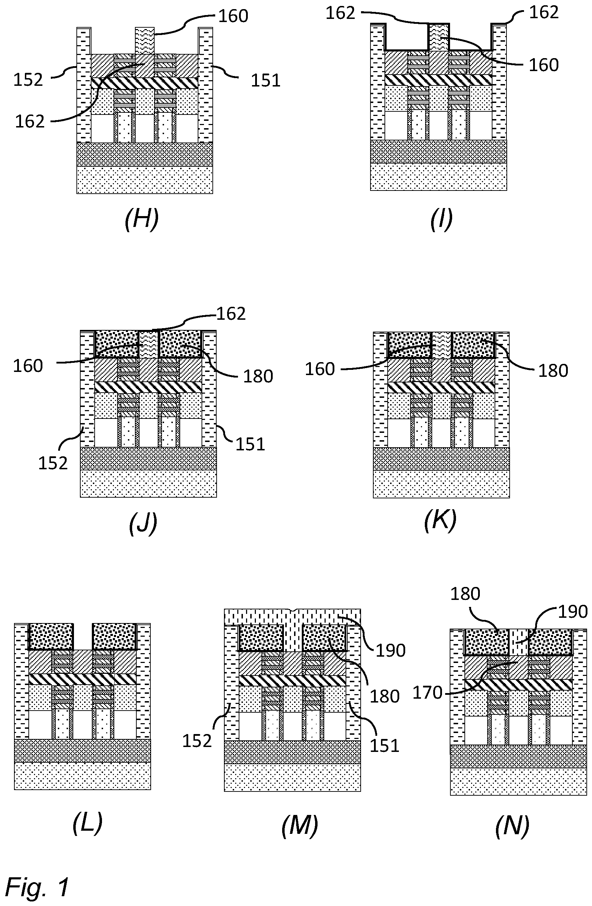

The fins 110a-e illustrated in Figs. 1-8 may be seen as similar to the fin 110 illustrated in Fig. 0. However, it should be understood that other types of fins 110 may be used. In particular, any suitable number of stacked layers per device can be used. As an example, fins 110 with a single set of channel layers for production of a NSFET may be used. Further, it should be understood that some of the features of the fin 110 in Fig. 0 may be formed between or after the steps of the disclosed method for forming the source/drain contact. Figs. 1A-1N illustrates schematic steps of a method for forming a source/drain contact.

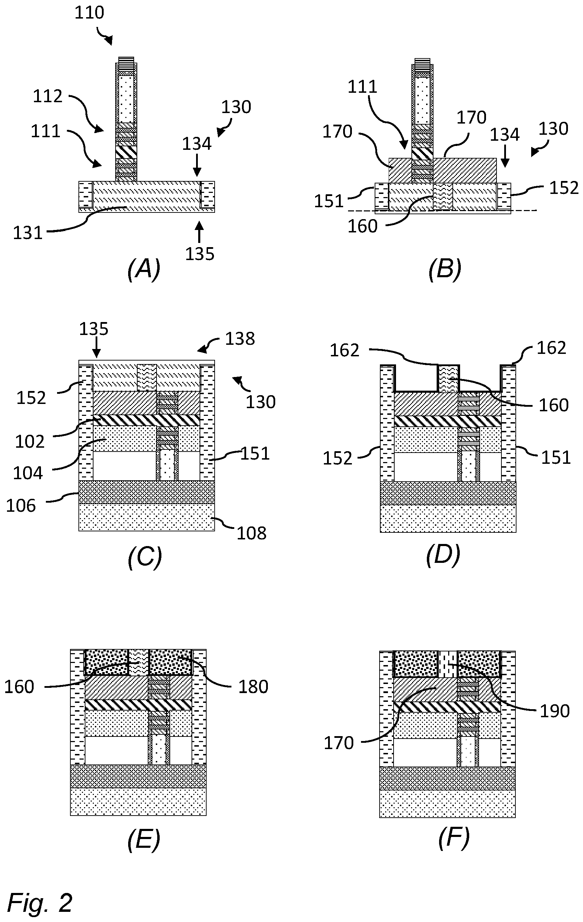

Fig. 1A illustrates providing a first and a second fin 110a, 110b on top of a substrate 130. However, at least one fin may be provided as will be further discussed in relation to Fig. 2.

The substrate 130 here comprises a foundational layer 133, which may, e.g., be comprised of silicon (Si). Above the foundational layer 133 is an insulator layer 132 for providing insulation. In turn, positioned on top of the insulator layer 132 is a silicon layer 131. Hence, the insulator layer 132 may here, e.g., be a Buried Oxide (BOX) layer. Thus, in Fig. 1A, the substrate 130 is a silicon on insulator substrate comprising a silicon layer 131 on top of, e.g., an oxide layer 132.The first and second fin 110a, 110b each comprises a first set of channel layers 111a, 111b. Each fin 110a, 110b may be seen as similar to the fin 110 illustrated in Fig. 0.

It is appreciated that the layers of the substrate 130 and the fins 110a, 110b may comprise any suitable material or materials, and that other or additional layers may be used. It is further appreciated that the fins 110a, 110b may be provided on a substrate 130 only comprising one layer, e.g. a silicon layer 131

The first and second fin 110a, 110b are further arranged between a first and second shallow trench isolation, STI, region 151, 152 extending into the substrate 130. The STI regions 151, 152 may comprise insulating materials such as silicon dioxide, which may be deposited into etched trenches within the substrate 130.

Further in, Fig. 1A, the first and second fin 110a, 110b are separated by a source/drain recess 140 for, e.g., a bottom device in the case of CFET.

Fig. 1B illustrates, from a frontside 134 of the substrate 130, forming a cavity 136 in the substrate 130 proximate to the first and second fins 110a, 110b. In the illustrated case, the cavity 136 is formed between the first and second fin 110a, 110b. In particular, the cavity in Fig. 1B has a width equal to a distance between the first fin 110a and the second fin 110b.

Further, the cavity 136 is here seen to be formed below the source/drain recess 140. Thus, in a sense, the source/drain recess 140 is extended.

The cavity 136 is also formed such that the cavity 136 does not extend through the whole silicon layer 131 of the substrate 130. In other words, the cavity 136 forms a trench in the silicon layer 131. Further, in the example when the substrate 130 is a silicon on insulator substrate, part of the silicon layer 131 remains between the cavity 136 and the insulator layer 132.

In particular, a bottom level of the cavity 136 is substantially equal to a bottom level of the first and second STI regions 151, 152. As depicted in Fig. 1B, a bottom of the cavity 136 is in level with a bottom of the first STI region 151 and a bottom of the second STI region 152 (see dashed line). Hence, as the first and second STI regions 151, 152 and the cavity 136 extend equally deep into the substrate 130. Specifically, the STI regions 151, 152 and the cavity 136 extend equally deep into the silicon layer 131 such that an equally thick part of the silicon layer 131 remains below the cavity 136 as below each of the first and second STI regions 151, 152.

However, it is appreciated that a difference/distance between the bottom level of the cavity 136 and the bottom level of the first and second STI regions 151, 152 may be within 10 nm, preferably within 5 nm.

In Fig. 1C, a sacrificial plug 160 has been formed in the cavity 136, and a source/drain region 170 has been formed on top of the sacrificial plug 160. Hence, the extended source/drain recess 140 has been at least partially filled.

The sacrificial plug 160 may, e.g., be formed by epitaxial growth. However the sacrificial plug may be formed by any suitable method, e.g., deposition.

The source/drain region 170 is further in contact with the first set of channel layers 111a, 111b of the first and second fin 110a, 110b. Fig. 1C illustrates that source/drain regions 170 may be formed at both ends of the fin.

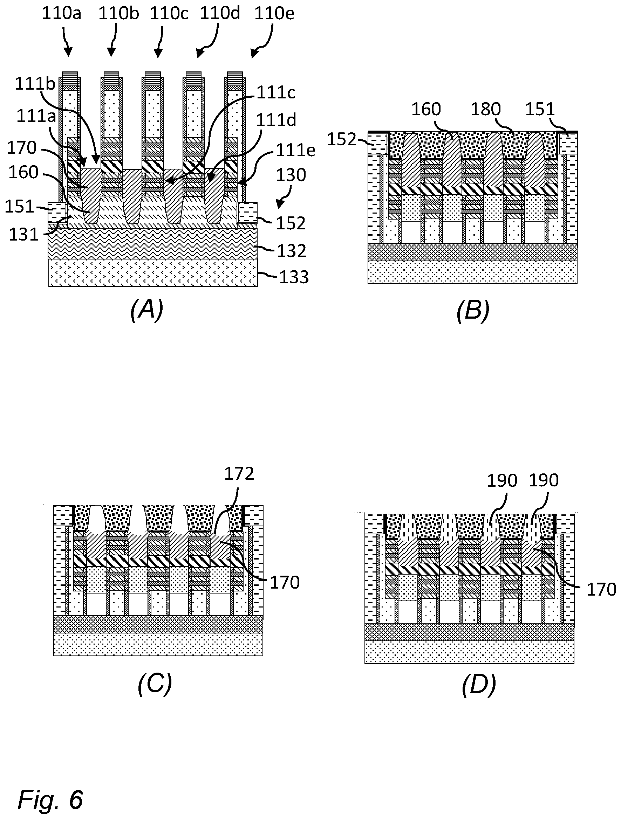

Even though shown as one step in Fig. 1C, forming of the source/drain region 170 and filling the cavity 136 with the sacrificial plug 160, may be performed as separate steps. However, as will be further discussed in relation to Fig. 6, the material of the sacrificial plug 160 may be the same (or similar) as a material used for forming the source/drain region 170.

Further in Fig. 1C, the cavity 136 has been filled such that the sacrificial plug 160 completely fills the cavity. In other words, a bottom level of the sacrificial plug is substantially in level with the bottom levels of the first and second STI regions 151, 152.

When producing CFETs, source/drain regions 104 may further be formed for the second sets of channel layers 112a, 112b, as illustrated in Fig. 1D. As further illustrated in Fig. 1D, a laterally extended middle dielectric isolation layer 102 may be formed by providing dielectric material at a height of the middle dielectric isolation 113 of the respective first and second fins 110a, 110b. It is appreciated that the middle dielectric isolation layer 102 may be thinner or thicker than the middle (or vertical) isolation layer 113 within the fins' 110a, 110b structure.

As illustrated in Fig. 1D, the first 151 and second 152 shallow trench isolation may extend further vertically. As further illustrated in Fig. 1D, a bonding layer 106 may be provided to facilitate bonding to a carrier wafer 108 (illustrated in Fig. 1E). Although not shown, it is to be understood that layers (such as MOL and BEOL) may be arranged in-between the devices and the bonding layer 106.

In Fig. 1E, a carrier wafer 108 has been bonded to the bonding layer 106.

In an example, the device may here be turned upside down and placed on the carrier wafer 108. In particular, the steps performed from the backside 135 of the substrate 130 may be performed when the device is flipped. Hence, Figs. 1E-N shows the backside 135 of the substrate 130 being oriented upwards, i.e., the device is flipped 180 degrees.

Figs. 1F and 1G illustrates removal of the foundational layer 133 and the insulator layer 132, respectively, from the substrate 130.

The removal of the foundational layer 133 and the insulator layer 132 are removed from the backside 135 of the substrate 130, (e.g. using etching, grinding, and/or CMP).

Hence, a bottom of the silicon layer 131 is exposed.

Further, Fig. 1H illustrates the removal of the silicon layer 131. In particular, from the backside 135 of the substrate 130, a first region 138 (marked in Fig. 1G) of the substrate 130 has now been removed. The first region 138 of the substrate 130 being a region between the first and second STI region 151, 152 and around the sacrificial plug 160.

In Fig. 1H, the sacrificial plug 160 is exposed on all sides except where the plug 160 is in contact with the source/drain region 170.

Fig. 1I illustrates a step of forming an etch-stop layer 162 on a bottom surface of the sacrificial plug 160 and on respective bottom surfaces of the first and second STI region 151, 152.

In Fig. 1J, a dielectric material 180 has been formed between the first and second STI region 151, 152 and around the sacrificial plug 160.

Notably, as seen in Fig. 1J, the dielectric material is formed around the lateral sides of the sacrificial plug 160. However, although not shown, dielectric material 180 may also have been formed below the sacrificial plug 160. Hence, the method may further comprise removing the dielectric material 180 below the sacrificial plug 160 selectively to the etch-stop layer 162 on the bottom surface of the sacrificial plug 160 by etching and/or chemical mechanical polishing, CMP.

Fig. 1K illustrates the removal of the etch-stop layer 162 from the bottom surface of the sacrificial plug 160. The removal of the etch-stop layer 162 may be performed using, e.g., wet etch, dry etch, and/or CMP.

In Fig. 1L, the sacrificial plug 160 has been removed. The sacrificial plug may, e.g., be removed through etching.

Further, Fig. 1M illustrates replacing the sacrificial plug 160 with a metal 190) such that the metal 190 is in electrical contact with the source/drain region 170. The metal 190 may, e.g., be deposited.

As seen in Fig. 1M, the metal 190 has been deposited also below the dielectric material 180 and the first and second STI regions 151, 152, e.g. due to the method of deposition or forming of the metal 190.

Fig. 1N then shows the removal of the excess metal such that only the metal 190 acting as a contact to the source/drain region 170 remains. In other words, only the metal 190 surrounded by the dielectric material 180 remains. Thus the metal 190 forms a source/drain contact.

The removal of the excess metal may be performed by, e.g., wet etch, dry etch, and/or CMP,

Figs. 2A-2F illustrates schematic steps of a method for forming a source/drain contact for a device only comprising one fin 110.

To avoid undue repetition, only a limited number of schematic method steps are shown and briefly described here. In particular, the method for forming a source/drain contact when there is only one fin 110 may benefit and largely correspond to the steps described in relation to any of Figs. 1A-1N. It is generally to be understood that any number of fins may be used for the steps disclosed herein.

In Fig. 2A, one fin 110 is provided on top of a substrate 130 (i.e. on a frontside 134 of the substrate 130). The fin 110 comprises a first set of channel layers 111 and a second set of channel layers 112, and is arranged between a first and second shallow trench isolation, STI, region 151, 152 extending into the substrate 130.

The substrate 130 here comprises a silicon layer 131. The silicon layer 131 is here seen to extend between and under the first and second STI regions 151, 152.

In Fig. 2B, a cavity in the substrate 130, proximate to the fin 110, has been formed and filled with a sacrificial plug 160 from a frontside 134 of the substrate 130. Further, a source/drain region 170 has been formed on top of the sacrificial plug 160, and in contact with the first set of channel layers 111 of the fin 110.

As further depicted in Fig. 2B, the cavity is formed in the substrate 130 such that a bottom level of the sacrificial plug 160 is substantially equal to a bottom level of the first and second STI region 151, 152 (see dashed line).

Fig. 2C illustrates the structure after formation of source/drain regions 104 for the second set of channel layers 112, providing laterally extended middle dielectric isolation layer 102, providing a bonding layer 106, and bonding to carrier wafer 108.

Fig. 2C further shows the first 151 and second 152 STI regions more thoroughly to highlight, in a simplified manner, the presence of extra isolation layers. In other words, the first and second STI region 151, 152 extend from their previously shown positions up to the bonding layer 106. Further, for simplicity, layers (such as MOL, BEOL) in-between the devices and the bonding layer 106 are not explicitly shown in Fig. 2C.

In Fig. 2D, a first region 138 of the substrate 130 has been removed from the backside 135 of the substrate 130. The first region 138 of the substrate 130 being the region between the first and second STI region 151, 152 and around the sacrificial plug 160.

Further, an etch-stop layer 162 has been formed on a bottom surface of the sacrificial plug 160 and on respective bottom surfaces of the first and second STI region 151, 152.

Fig. 2E depicts the forming of a dielectric material 180 between the first and second STI region 151, 152 and around the sacrificial plug 160. Further the etch-stop layer on the bottom surface of the sacrificial plug 160 has been removed.

Lastly, in Fig. 2F, the sacrificial plug 160 has been replaced with a metal 190 such that the metal 190 is in electrical contact with the source/drain region 170.

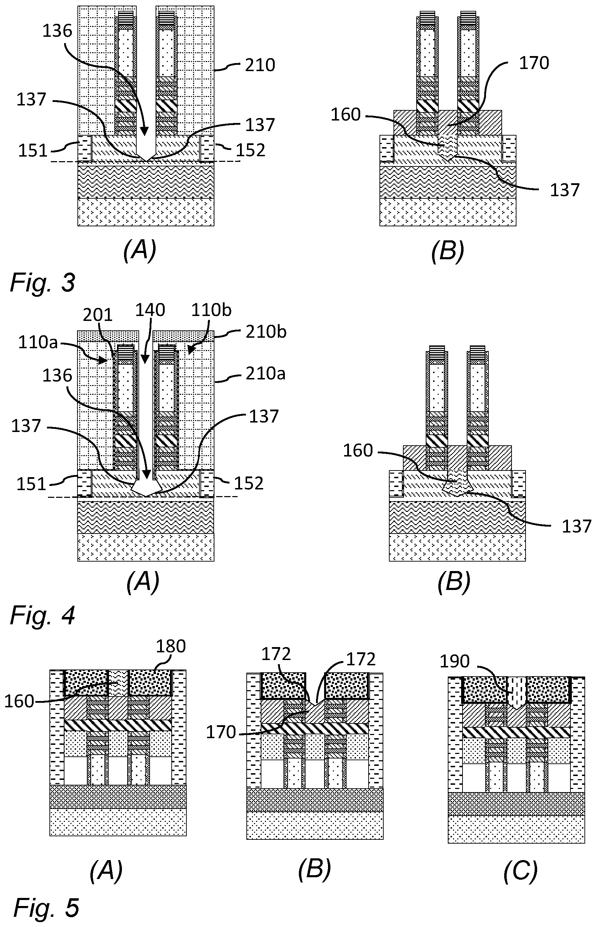

Figs. 3A-B illustrate alternative or additional steps of forming the cavity 136 and the sacrificial plug 160.

To avoid undue repetition, only a limited number of schematic method steps are shown and briefly described here, and further reference is made to Figs. 1A-1N and 2A-2F.

In Fig. 3A, the cavity 136 has been shaped such that a bottom part of the cavity comprises an inclined plane 137 (i.e. a sloped profile). The shaping may be done by etching, e.g. wet etching. For example, the source/drain recess 140 and/or the cavity 136 may be formed by dry etching. The cavity 136 may subsequently be shaped by wet etching.

Here, the bottom part of the cavity 136 comprises two inclined planes 137 forming a V-shape. However, the bottom part of the cavity 136 may comprise any number of inclined planes.

Fig. 3A also illustrates a mask 210, which may be used to protect parts that should not be etched.

The larger contact surface provided by the V-shape of the cavity 136 may facilitate epitaxial growth. Hence, as further seen in Fig. 3B, a sacrificial plug 160 with no or minimized defects may be provided in the cavity 136.

Notably, as depicted in Fig. 3A, the bottom level of the cavity 136 comprising the inclined plane 137 is in level with the bottom levels of the first and second STI regions 151, 152 (see dashed line).

In Fig. 3B, a sacrificial plug 160 has been formed in the cavity 136 and a source/drain region 170 has been deposited or grown on top of the sacrificial plug 160.

Figs. 4A-B illustrate alternative or additional steps of enlarging a cavity 136 and sacrificial plug 160.

To avoid undue repetition, only a limited number of schematic method steps are shown and briefly described here, and further reference is made to Figs. 1A-N, 2A-F, and 3A-B.

As depicted in Fig. 4A, the step of forming the cavity 136 may further comprise enlarging the cavity 136 by lateral etching, e.g. wet etching, such that a width of the enlarged cavity is larger than a width of the source/drain recess 140.

In Fig. 4A, the channel ends of the fins 110a, 110b in the source/drain recess 140 are protected to avoid damage during the step of enlarging the cavity 136. Here, the channel ends are protected by a liner 201, however, any suitable means for protecting the channel ends may be used.

Further, when a bottom part of the cavity 136 comprises an inclined plane 137, enlarging of the cavity 136 may be facilitated. A cavity 136 with a flat bottom may, e.g., be enlarged by developing several inclined planes 137.

Notably, as depicted in Fig. 4A, the bottom level of the cavity 136 is in level with the bottom levels of the first and second STI regions 151, 152 (see dashed line).

The figure also illustrates a mask in the form of a soft mask 210a and a hard mask 210b, which may be used to protect parts that should not be etched.

In Fig. 4B, the protective liner 201 has been removed and the cavity 136 has been filled with a sacrificial plug 160.

Further, a source/drain region 170 has been deposited or grown on top of the sacrificial plug 160.

Figs. 5A-C illustrate alternative or additional steps of replacing a sacrificial plug with a metal.

To avoid undue repetition, only a limited number of schematic method steps are shown and briefly described here, and further reference is made to Figs. 1A-N and 2A-F.

In Figs. 5A-B a step of etching through the sacrificial plug 160 and into the source/drain region 170 is depicted. The sacrificial plug 160 and source/drain region 170 are etched through such that an inclined plane 172 is formed at a bottom of the source/drain region 170.

In Fig. 5B, two inclined planes 172 are formed at the bottom of the source/drain region 170, specifically, the two inclined planes 172 have here been formed in a V-shape. However, any number of inclined planes 172 may be used to form any suitable shape of the etch into the source/drain region 170.

In Fig. 5C, a metal 190 has been deposited on the inclined plane 172 of the source/drain region 170 and replaced the sacrificial plug 160.

Figs. 6A-D illustrate alternative steps of forming the sacrificial plug 160, the source/drain region 170, and the metal 190.

To avoid undue repetition, only a limited number of schematic method steps are shown and briefly described here, and further reference is made to Figs. 1A-N, 2A-F, 3A-B, 4A-B, and 5A-C.

In the following examples, five fins 100a-e are arranged on top of a substrate 130. However, it is to be understood that any number of fins may be used.

In Fig. 6A, the sacrificial plug 160 and the source/drain region 170 comprises a same material, however the material's elemental composition may be different for the sacrificial plug 160 and the source/drain region 170. In other words, the cavities 136 formed (not shown) in the substrate 130 have here been filled with a material such that also at least a first set of channel layer 111a-e of each fin 110a-e is covered, hence the material used here acts as both the sacrificial plug 160 and the source/drain region 170.

The cavities 136 may be formed in conjunction with the formation of the source/drain recess 140. For example, the source/drain recess 140 may be etched such that it continues into the substrate 130, e.g. into the first region 138 of the substrate 130.

The material acting as both source/drain region 170 and sacrificial plug 160 may, e.g., be silicon-germanium (Si₁₋ₓGeₓ) for various Ge percentages, or other group-IV materials.

In a way of example, a source/drain recess between each neighboring fin may extend into the substrate 130 (i.e. similar to the discussed cavities). However, the source/drain recess does not reach below the silicon layer 131. In particular, by not reaching below the silicon layer 131, epitaxial growth from the bottom can help attain overall higher source/drain epi quality, i.e., with less defects, and it may help induce higher stress in the channel. Also, direct contact with the insulator layer 132 (which may be a BOX layer comprising a potential oxygen source) is avoided. Further, where there is still a silicon layer 131 underneath the bottom of the source/drain region and on top of the BOX 132, higher stress from source/drain is facilitated. Notably, similar process flow can also then be used in bulk silicon wafers.

Although not shown here, the shape of the cavity/recess may be enlarged at a bottom as previously described.

The device schematically illustrated here otherwise largely correspond to the device shown Fig. 1A. For example, the substrate 130 here comprises a silicon layer 131, an insulator layer 132, and a foundational layer 133.

Fig. 6A also shows a bottom level of each sacrificial plug 160 being in level with the first and second STI regions 151, 152.

In Fig. 6B the steps discussed in relation to Figs. 1D-J may have been performed. In particular, a dielectric material 180 has now been formed or deposited between the first and second STI regions 151, 152 and around the sacrificial plugs 160.

The silicon layer 131 may have been selectively removed by one or more processes, e.g. such as wet-etch and/or plasma-etch. In addition, in case of silicon residues (e.g. at corners), oxidation processes could be utilized to transform such silicon residue into oxide.

In Fig. 6C, similarly as to in Fig. 5B, etching from the backside and through the sacrificial plug 160 and into the source/drain region 170 has been performed. The sacrificial plug 160 and source/drain region 170 are etched through such that an inclined plane 172 is formed at a bottom of the source/drain region 170. However, the sacrificial plug 160 may be etched to any suitable depth. For example, the bottom of the source/drain region 170 may be flat.

Etch-back of the sacrificial plug 160 may be done in a controllable way and with high selectivity to surrounding layers by one or more processes (e.g. a combination of processes such as dry-etch and wet-etch).

The upside-down V-shape into the source/drain region 170 may, e.g., be obtain using wet-etch.

Notably, since the sacrificial plug 160 and the source/drain region 170 here are made of the same material, it may not be evident what forms part of the sacrificial plug 160 and what forms part of the source/drain region 170. However, the source/drain region 170 may correspond to at least the part of the material being in direct contact with the first set of channel layers 111a-e of the fins 110a-e.

Fig. 6D depicts the forming of metal 190 in the parts where the sacrificial plugs 160 (and part of the source/drain regions 170) where removed.

Hence, metal contacts to the source drain regions 170 have been formed (i.e., source/contacts).

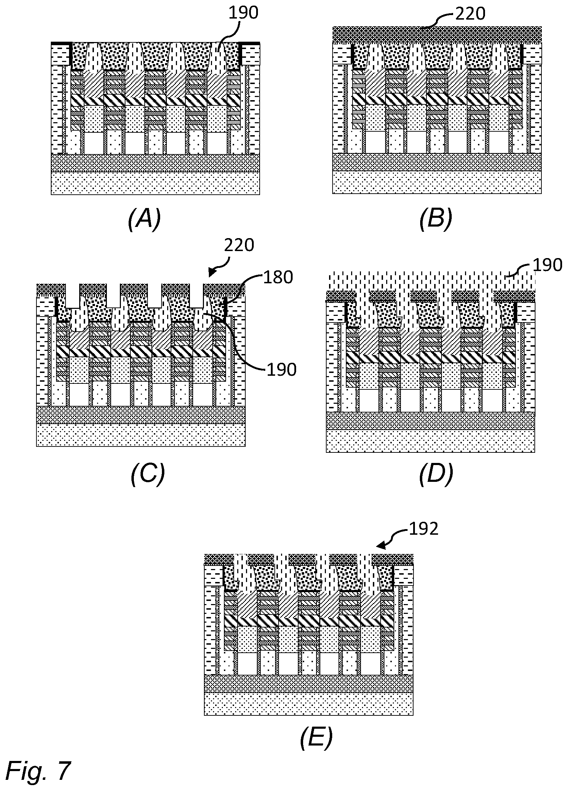

Figs. 7A-E illustrate additional steps of a method for forming interconnect lines 192. The device structure is here the same as discussed in relation to Figs. 6A-D, however, the steps illustrated here may also be performed on the devices depicted in any of Figs. 1, 2, 3, 4, and 5.

Fig. 7A corresponds to Fig. 6D, where the source/drain contacts are represented by the metals 190.

In Fig. 7B a dielectric layer 220 has been deposited.

Further, in Fig 7C, the dielectric layer 220 has been patterned, e.g. lithographically patterned, to form openings for the interconnect lines 192. As illustrated, the openings may not necessarily align perfectly with the metal 190 forming the source/drain contacts. This may be due to overlay and/or alignment control issues during back side lithography. However, if the source/drain contact has been produced by etching from the frontside, then alignment issues during the formation of interconnect lines 192 may have a small or negligible impact on the quality of the device.

As illustrated, an etch may be performed into the dielectric material 180 or into both the dielectric material 180 and partially into the metal 190 of the source/drain contacts. The latter may facilitate a better contact to the interconnect lines 192.

In Fig. 7D, further metal 190 is deposited, thus filling the openings in the dielectric layer 220.

In Fig. 7E excess metal has been removed. Hence, metal interconnect lines 192 have been formed.

The excess metal may, e.g., be removed by a CMP process, wet etch, and/or dry etch.

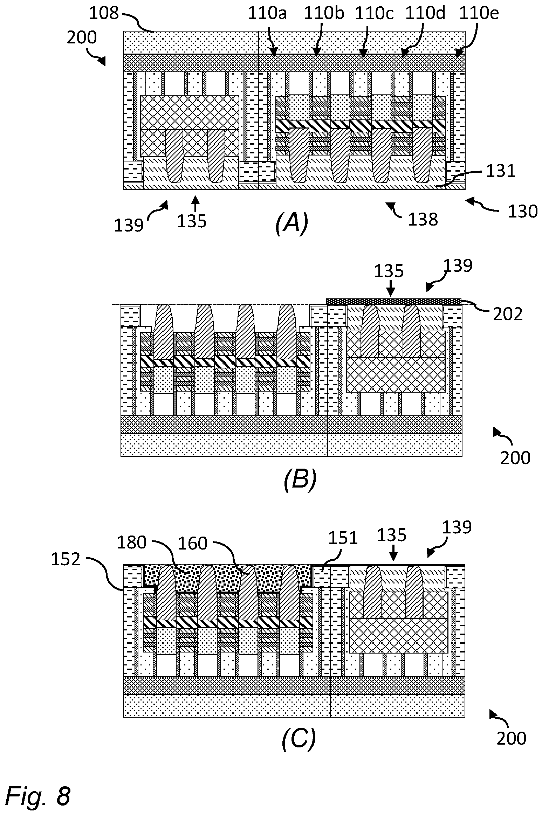

Figs. 8A-B schematically illustrates an example where there is further a semiconductor structure 200 arranged on top of the substrate 130.

To avoid undue repetition, only a limited number of schematic method steps are shown and briefly described here, and further reference is made to Figs. 1A-N, 2A-F, 3A-B, 4A-B, 5A-C, 6A-D, and 7A-E.

Fig. 8A specifically illustrates, in addition to the fins 110a-e, a semiconductor structure 200 on top of a second region 139 of the substrate 130.

As seen in Fig. 8B, the second region 139 of the substrate 130 is protected by a protective layer 202 during the step of removing the first region 138 of the substrate 130.

The protective layer 202 protecting the second region 139 of the substrate 130 may, e.g., be a shallow trench isolation liner or a dielectric liner (e.g., a Silicon Nitride liner) acting as an etch stop layer for, e.g., dry-etch, wet-etch and/or CMP.

Further, the silicon layer 131 has been removed in the first region 138.

In Fig. 8C the protective layer 202 has been removed from the second region 139. Further, a dielectric material 180 has deposited between the first and second STI regions 151, 152 and around the sacrificial plugs 160 in the first region 139.

Although not shown here, the steps described and illustrated in Figs. 1, 2, 3, 4, 5, 6, and 7 may have a semiconductor structure 200 arranged in relation thereto (i.e. the devices in the figures may have a semiconductor structure 200 arranged next to or in connection to them), e.g. on the substate 130. In particular, the steps previously described may be performed further on the device depicted in Fig. 8C for forming source/drain contacts.

The semiconductor structure 200 may be any suitable generic device, structure, or combination of structures. For example, the semiconductor structure 200 may be any non-logic device, e.g., such as a diode and/or an ESD protection diode.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a source/drain contact, the method comprising:
providing at least one fin (110) on top of a substrate (130), the at least one fin (110) comprising at least a first set of channel layers (111), the at least one fin (110) being arranged between a first and second shallow trench isolation, STI, region (151, 152) extending into the substrate (130);
from a frontside (134) of the substrate (130):
forming a cavity (136) in the substrate (130) proximate to the at least one fin (110),
forming a sacrificial plug (160) in the cavity (136), and
forming a source/drain region (170) on top of the sacrificial plug (160), and in contact with the first set of channel layers (111) of the at least one fin (110); and
from a backside (135) of the substrate (130):
removing a first region (138) of the substrate (130), the first region (138) of the substrate (130) being a region between the first and second STI region (151, 152) and around the sacrificial plug (160),
forming a dielectric material (180) between the first and second STI region (151, 152) and around the sacrificial plug (160), and
replacing the sacrificial plug (160) with a metal (190) such that the metal (190) is in electrical contact with the source/drain region (170),
wherein a bottom level of the cavity (136) is substantially equal to a bottom level of the first and second STI region (151, 152).

2. The method according to claim 1, wherein the at least one fin (110) comprises a first and a second fin (110a, 110b), wherein the first and second fin (110a, 110b) are separated by a source/drain recess (140), and wherein the cavity (136) is formed below the source/drain recess (140).

3. The method according to claim 1 or 2, further comprising:
forming an etch-stop layer (162) on a bottom surface of the sacrificial plug (160) and on respective bottom surfaces of the first and second STI region (151, 152), before forming the dielectric material (180) between the first and second STI region (151, 152) and around the sacrificial plug (160), wherein forming the dielectric material (180) comprises also forming the dielectric material (180) below the sacrificial plug (160);
removing the dielectric material (180) below the sacrificial plug (160) selectively to the etch-stop layer (162) on the bottom surface of the sacrificial plug (160) by etching and/or chemical mechanical polishing, CMP; and
removing the etch-stop layer (162) from the bottom surface of the sacrificial plug (160) before replacing the sacrificial plug (160) with metal (190).

4. The method according to any one of claims 1-3, wherein the sacrificial plug (160) is formed by epitaxial growth.

5. The method according to any one of the preceding claims, wherein the sacrificial plug (160) and the source/drain region (170) comprises a same material.

6. The method according to any one of the preceding claims, the step of forming the cavity further comprising shaping the cavity (136) such that a bottom part of the cavity comprises an inclined plane (137).

7. The method according to any one of the preceding claims, when dependent on claim 2, the step of forming the cavity further comprising enlarging the cavity (136) by lateral etching, such that a width of the enlarged cavity is larger than a width of the source/drain recess (140).

8. The method according to claim 7, further comprising:
protecting channel ends in the source/drain recess (140) during the step of enlarging the cavity (136).

9. The method according to any one of the preceding claims, wherein the substrate (130) is a silicon on insulator substrate comprising a silicon layer (131) on top of a buried oxide layer (132).

10. The method according to claim 9, wherein part of the silicon layer (131) of the silicon on insulator substrate remains between the cavity (136) and the oxide layer (132) of the silicon on insulator substrate, after forming the cavity (136).

11. The method according to any one of the preceding claims, wherein replacing the sacrificial plug (160) with the metal (190) further comprises:
etching through the sacrificial plug (160) and into the source/drain region (170) such that an inclined plane (172) is formed at a bottom of the source/drain region (170); and
depositing the metal (190) on the inclined plane (172) of the source/drain region (170).

12. The method according to any one of the preceding claims, further comprising:
forming, from the backside (135), a metal interconnect line (192) on the metal (190) replacing the sacrificial plug (160).

13. The method according to any one of the preceding claims, further comprising:
protecting a second region (139) of the substrate (130) during the step of removing the first region (138) of the substrate (130).

14. The method according to any one of the preceding claims, further comprising:
providing, in addition to the at least one fin (110), a semiconductor structure (200) on top of the substrate (130).
